# FASCICULE DE BREVET EUROPEEN

(11) **EP 0 665 559 B1**
(45) Date de publication et mention de la délivrance du brevet: **26.06.1996**
(21) Numéro de dépôt: 95400188.9
(22) Date de dépôt: 27.01.1995
(51) Int. Cl.: G11C 16/04

(54) **Bascule bistable non volatile programmable, à reduction de parasites en mode de lecture, notamment pour circuit de redondance de mémoire**
Nichtflüchtiger programmierbarer Flip-Flop mit Verminderung von parasitären Effekten beim Lesen für Speicherredundanzschaltung
Non volatile programmable flip-flop, with reduction of parasitic effects in read mode, especially for memory redundancy circuit

(30) Priorité: 31.01.1994 FR 9401036
(43) Date de publication de la demande: 02.08.1995
(73) Titulaire: SGS-THOMSON MICROELECTRONICS S.A., F-94250 Gentilly (FR)
(72) Inventeur: Mirabel, Jean Michel, F-75116 Paris (FR); Devin, Jean, F-75116 Paris (FR)
(74) Mandataire: Schmit, Christian Norbert Marie

(56) Documents cités:
- EP-A- 0 525 680
- IEEE JOURNAL OF SOLID-STATE CIRCUITS., vol.17, no.5, Octobre 1982, NEW YORK US pages 847 - 851 DONALDSON ET AL 'SNOS 1Kx8 static nonvolatile RAM'
- IEEE JOURNAL OF SOLID-STATE CIRCUITS., vol.22, no.5, Octobre 1987, NEW YORK US pages 684 - 692 CIAOCA ET AL 'A million-cycle CMOS 256K EEPROM'

## Description

L'invention concerne les circuits intégrés. Elle a pour objet une bascule bistable non volatile, programmable électriquement. Elle est destinée essentiellement, bien que non exclusivement, à être utilisée dans un circuit de redondance de mémoire en circuit intégré.

Pour bien faire comprendre l'invention dans le contexte où elle a été imaginée, on va d'abord rappeler sommairement les principes des circuits de redondance utilisés actuellement dans les mémoires de grande capacité.

Les circuits de redondance d'une mémoire sont mis en oeuvre lorsque des défauts apparaissent dans les rangées (lignes de mot servant à adresser la mémoire) ou les colonnes (lignes de bit transportant les données à lire ou écrire dans la mémoire).

Par exemple, si une colonne est défectueuse, on la remplace par une colonne de redondance de la manière suivante : l'adresse de la colonne défectueuse est mise en mémoire dans une mémoire d'adresse défectueuse; cette mémoire d'adresse défectueuse est une mémoire de type adressable par son contenu (appelée ci-après mémoire CAM); chaque fois qu'une adresse est appliquée à la mémoire principale, cette adresse est également appliquée à la mémoire CAM. Si l'adresse appliquée est identique à l'adresse mémorisée, un circuit de redondance est mis en service et agit pour déconnecter la colonne défectueuse et connecter à sa place une colonne redondante, d'une manière invisible pour l'utilisateur.

En pratique, selon l'organisation de la mémoire principale, si une colonne est défectueuse, on remplacera plutôt un groupe de colonnes contenant cette colonne défectueuse par un groupe de colonnes de redondance : en général, si un groupe de colonnes est défini par un bit d'adresse de la mémoire de grande capacité, c'est ce groupe de colonnes qu'on remplacera dans son ensemble. Dans la suite, pour simplifier, on se contentera de parler du remplacement d'une colonne plutôt que du remplacement d'un groupe de colonnes.

Pour une mémoire principale de plusieurs mégabits, on prévoit la possibilité de réparer plusieurs défauts; il y a donc autant de colonnes de redondance que de colonnes ou de ligne en défaut qu'on veut pouvoir réparer. A chaque colonne de redondance est associée une mémoire CAM respective qui contient l'adresse d'une colonne défectueuse. Si on veut réparer N défauts, il faut N colonnes de redondance et N mémoires CAM. Typiquement N=36 pour une mémoire de 4 ou 16 mégabits.

Si une colonne de la mémoire principale est désignée par une adresse de M bits (par exemple M=5), chaque mémoire CAM contient au moins M+1 bit : M bits pour définir l'adresse d'une colonne défectueuse et un bit de validation pour indiquer que le circuit de redondance correspondant à cette mémoire CAM doit effectivement être activé lorsque l'adresse défectueuse est appliquée à la mémoire CAM.

Pour réaliser les mémoires CAM, on a d'abord utilisé des groupes de fusibles physiques, grillés électriquement ou grillés par un faisceau laser, chaque fusible représentant un bit d'adresse ou un bit de validation. Ces fusibles présentaient des inconvénients (fiabilité, encombrement, consommation, difficulté de programmation) et ont été rapidement remplacés par des cellules de mémoire non volatile non effaçables. Ces dernières présentaient également des inconvénients (consommation de courant importante), et on s'est orienté progressivement vers l'utilisation de bascules bistables programmables comprenant deux transistors à grille flottante pour chaque bit d'adresse ou de validation.

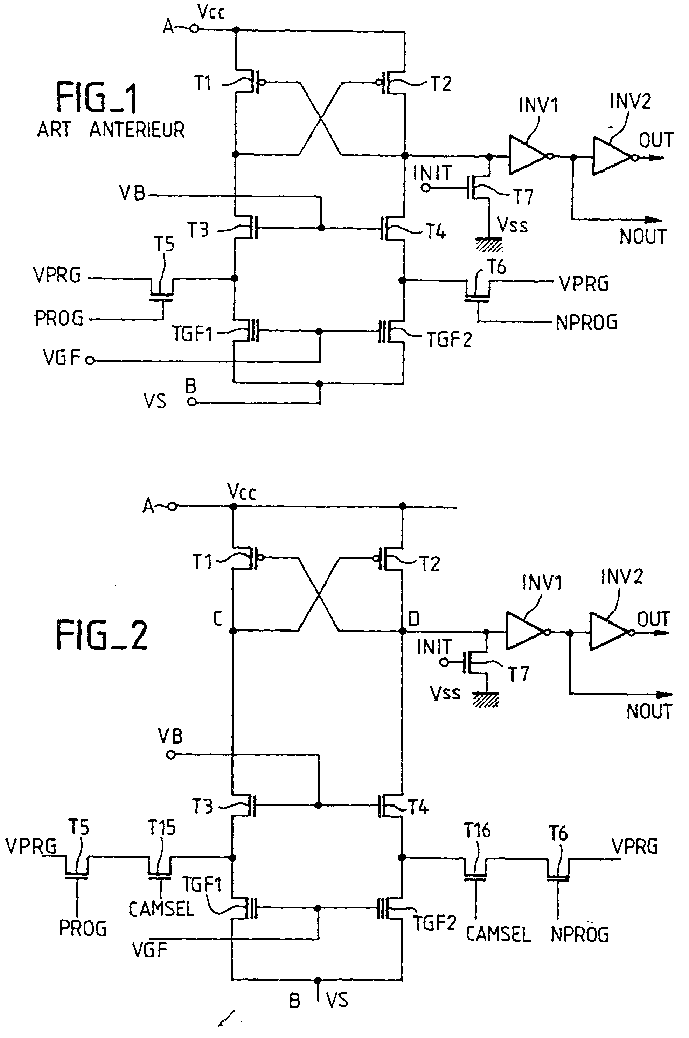

La figure 1 représente une bascule bistable programmable non volatile de la technique antérieure, constituant une cellule de mémorisation d'un bit d'adresse défectueuse (ou d'un bit de validation), et constituant donc une des M+1 cellules d'une mémoire CAM d'adresse défectueuse.

La sortie OUT de cette cellule est à un niveau logique 0 ou à 1 selon l'état dans lequel la bascule est programmée. Cette sortie définit donc la valeur d'un bit d'adresse (ou la valeur du bit de validation).

Si la cellule correspond à un des M bits d'adresse défectueuse, la sortie de chaque cellule de ces M bits d'adresse est appliquée à une entrée de porte OU-Exclusif (non représentée). La porte OU-Exclusif reçoit sur une autre entrée un bit d'adresse correspondant, reçu par la mémoire principale; les sorties des portes OU-Exclusif correspondant aux différents bits d'adresse d'une même mémoire d'adresse défectueuse sont appliquées à une entrée d'une porte NOR (non représentée); la sortie de cette dernière fournit un niveau logique 1 uniquement s'il y a coïncidence entre tous les bits d'adresse 'appliqués et tous les bits correspondants de la mémoire d'adresse défectueuse. La sortie de la porte NOR est validée par la sortie de la cellule de mémoire correspondant au bit de validation, par exemple grâce à une porte ET (non représentée). La sortie de la porte ET est la sortie de la mémoire CAM et sert à mettre en service un chemin de redondance chaque fois que l'adresse appliquée à la mémoire principale correspond à l'adresse défectueuse enregistrée.

Dans le cas général, il y a N mémoires d'adresse défectueuse, par exemple N=36. Lors du test de la mémoire principale, la détection d'une colonne défectueuse déclenche le stockage de l'adresse de cette colonne dans une des mémoires CAM. Les différentes mémoires CAM sont ainsi successivement programmées au fur et à mesure de la détection des défauts. En fonctionnement normal de la mémoire principale, les adresses de celle-ci sont appliquées simultanément à toutes les mémoires CAM. S'il y a correspondance de l'adresse appliquée et de l'adresse stockée dans l'une d'elles, le chemin de redondance correspondant à celle-ci est activé.

Pour permettre la programmation d'une adresse défectueuse dans une mémoire CAM, on prévoit donc qu'un bit d'adresse respectif de la mémoire principale est appliqué à chaque cellule de la mémoire CAM. La programmation est effectuée sur ordre de l'appareil de test en cas de détection d'un défaut à l'adresse en cours de test.

La cellule de mémoire individuelle représentée à la figure 1 comporte deux branches avec un transistor à grille flottante TGF1, TGF2 dans chaque branche; les branches sont agencées de manière à former une bascule bistable dès qu'un de ces deux transistors est programmé; l'état de la bascule, représenté par la sortie OUT et correspondant à un bit d'adresse ou un bit de validation, est alors fonction de celui des deux transistors qui est programmé. Au départ les deux transistors sont dans un état non-programmé, ou état vierge. Lors du test de la mémoire, on programme l'un des deux transistors pour obtenir soit un 0 soit un 1 en sortie OUT de la cellule, définissant ainsi un état stable définitif 0 ou 1 de la cellule.

Plus précisément, la cellule de la figure 1 comprend deux branches identiques en parallèle entre une borne d'alimentation A (potentiel Vcc de l'ordre de 3 volts) et une borne B; la borne B est à un potentiel VS nul en mode de lecture ou de programmation et peut aussi être portée à un potentiel VS élevé (12 volts) en mode d'effacement si un mode d'effacement est prévu (flash EPROM); en série dans chaque branche, on trouve un transistor à canal P (T1, T2), un transistor à canal N (T3, T4), et un transistor à grille flottante (TGF1, TGF2). La grille du transistor à canal P (T1, T2) de l'une des branches est reliée au drain du transistor à canal P (T2, T1) de l'autre branche. Les grilles des transistors à canal N (T3, T4) sont reliées ensemble à un potentiel commun VB dont la valeur dépend du mode de fonctionnement (environ 1,8 volt en lecture; zéro volt en programmation ou effacement pour avoir 1 volt sur le drain des cellules en lecture). Les transistors T3 et T4 sont des transistors d'isolation pour empêcher la transmission aux transistors T1 et T2 des tensions relativement élevées appliquées aux transistors à grille flottante en mode de programmation ou effacement. Les grilles des transistors à grille flottante TGF1, TGF2, sont reliées à un potentiel commun VGF dépendant du fonctionnement (3 volts environ en lecture, 12 volts environ en programmation). La source de ces transistors est reliée au noeud B (potentiel VS). Les potentiels de drain des transistors à grille flottante sont contrôlés par des transistors T5 et T6 respectivement, permettant soit de relier le drain à un potentiel de programmation VPRG (transistor T5 ou T6 conducteur) soit de laisser le drain en haute impédance (transistor T5 ou T6 bloqué). En mode de programmation, la grille du transistor T5 est contrôlée par un signal de programmation PROG et la grille de T6 par un signal complémentaire NPROG. De la sorte on choisit selon l'état du signal PROG celui des deux transistors à grille flottante qui doit être programmé et celui qui doit rester vierge. En mode de lecture, le drain des transistors T5 et T6 reste en haute impédance, la tension VPRG n'étant pas appliquée à ces drains.

La cellule est appelée "bistable" car elle possède un état stable parmi deux possibles, l'état stable qu'elle prend dépendant de celui des deux transistors qui a été programmé. L'état de la cellule est lu sur le drain d'un des transistors à canal P (T2 par exemple). Ce drain est relié à l'entrée d'un premier inverseur INV1 suivi d'un deuxième inverseur INV2. La sortie de INV2 est la sortie OUT de la cellule. La sortie de INV1 sert de sortie complémentaire NOUT si on en a besoin.

Enfin, un transistor supplémentaire T7 peut permettre, uniquement en mode de test, pour éviter les noeuds flottants quand T3 et T4 sont bloqués, de mettre à la masse temporairement (pour une initialisation de l'état de la cellule à chaque remise sous tension) l'entrée de l'inverseur INV1; la grille de ce transistor est commandée par un créneau d'initialisation INIT produit par un circuit classique de remise sous tension ("Power On Reset") non représenté.

La présente invention a pour but d'améliorer les cellules bistables de l'art antérieur, pour les rendre plus efficaces, notamment dans les applications du genre qui a été décrit ci-dessus (redondance de mémoire).

Selon l'invention, on interpose un transistor d'isolation respectif entre d'une part le drain d'un transistor à grille flottante et le transistor (T5, T6) qui sert à appliquer une tension de programmation à ce drain.

L'invention concerne donc une cellule de mémoire programmable comprenant deux transistors à grille flottante et une bascule bistable dont l'état est défini par programmation d'un des deux transistors, de plus comportant deux transistors pour appliquer sélectivement à l'un seulement des deux transistors à grille flottante une tension permettant sa programmation, l'autre ne recevant pas cette tension, caractérisée en ce qu'un transistor d'isolation est intercalé entre chaque transistor d'application de la tension de programmation et le drain du transistor à grille flottante correspondant.

L'invention est applicablee à une cellule du type de la figure 1, c'est-à-dire comportant deux branches, chaque branche comportant un transistor à canal P en série avec un transistor à grille flottante respectif de cette branche, le drain du transistor à canal P de l'une des branches étant relié à la grille du transistor à canal P de l'autre branche.

Les transistors d'isolation sont rendus conducteurs en mode de programmation de la cellule considérée, mais ils peuvent être bloqués pour d'autre modes (notamment en mode de programmation d'autres batteries de cellules bistables, et surtout en mode de lecture).

Ces transistors d'isolation réduisent en particulier beaucoup l'influence des signaux qui transitent dans les chemins de programmation des différentes cellules. Dans l'application à la redondance d'une mémoire principale, ces chemins de programmation sont les circuits qui vont des décodeurs d'adresse de la mémoire principale jusqu'aux transistors à grille flottante. Ils sont en service lors de l'utilisation de la mémoire. Les signaux qui y circulent peuvent agir indirectement et de manière indésirable, à cause des capacités parasites, sur les fonctions de la bascule bistable, et notamment sur son état.

Les transistors d'isolation selon l'invention peuvent limiter l'influence de ces effets parasites s'ils sont bloqués.

L'invention s'applique principalement aux mémoires en circuit intégré comportant une mémoire principale et des circuits de redondance; les cellules de mémoire servent à stocker des adresses d'éléments défectueux de la mémoire principale. Les transistors d'isolation sont de préférence commandés par un signal actif qui les rend conducteurs, le signal actif étant fourni par des circuits de test à un groupe de cellules de mémoire lorsqu'une adresse d'élément défectueux doit être stockée dans ce groupe. Ce signal est rendu inactif en mode d'utilisation normal de la mémoire.

Les caractéristiques et avantages de l'invention apparaîtront à la lecture de la description détaillée qui suit et qui est faite en référence aux dessins annexés dans lesquels :
- la figure 1, déjà décrite représente une cellule de mémorisation connue;
- la figure 2 représente un mode de réalisation d'une cellule selon l'invention.

Une cellule de mémorisation non volatile selon l'invention est représentée à la figure 2. Elle est constituée pour l'essentiel comme celle de la figure 1, avec deux transistors supplémentaires qu'on appellera transistors d'isolation. La description faite à propos de la figure 1 reste valable pour la figure 2 avec les modifications suivantes : un premier transistor d'isolation T15 est intercalé entre le transistor T5 (transistor d'application de la tension de programmation VPRG) et le drain du transistor à grille flottante TGF1. Un deuxième transistor d'isolation T16 est intercalé entre le transistor T6 (second transistor d'application de la tension VPRG) et le drain de l'autre transistor à grille flottante TGF2.

Les transistors T15 et T16 sont commandés en principe par un même signal CAMSEL.

Le signal CAMSEL est tel que les transistors T15 et T16 soient bloqués en mode de lecture et conducteurs en mode de programmation de la cellule. On peut prévoir que le signal CAMSEL au niveau actif (qui rend les transistors conducteurs) est fourni simultanément à toutes les cellules bistables d'un groupe de cellules et qu'il n'est pas fourni aux autres groupes de cellules. Dans l'application à la redondance d'une mémoire principale, cela veut dire que lors du test de la mémoire, une adresse défectueuse peut être trouvée et donne lieu à une programmation de cette adresse dans un groupe de cellules destiné à stocker une adresse défectueuse. C'est ce groupe de cellules qui reçoit alors le signal CAMSEL au niveau actif. Les autres groupes de cellules (correspondant à des adresses défectueuses déjà stockées, ou encore libres pour la suite du test de la mémoire principale) ne reçoivent pas le signal CAMSEL et la tension de programmation VPRG ne peut pas leur être appliquée. Le signal CAMSEL, normalement inactif, est donc fourni par les circuits de test (intérieurs et/ou extérieurs) de la mémoire principale, et il est mis au niveau actif successivement pour les différents groupes de cellules au fur et à mesure que des défauts sont trouvés et nécessitent le stockage d'une adresse.

En mode de lecture, le signal CAMSEL reste inactif; les transistors T15 et T16 restent bloqués. De toute façon la tension VPRG n'a pas besoin d'être transmise aux drains des transistors à grille flottante en mode de lecture. Pour l'application au stockage des adresses défectueuses d'une mémoire principale, le mode de lecture est le mode normal de fonctionnement, puisque la programmation des cellules n'a lieu que lors du test de la mémoire principale.

Les grilles des transistors T5 et T6 reçoivent en permanence, en mode de lecture, les signaux d'adresse appliqués à la mémoire principale. Bien que les drains de ces transistors ne reçoivent pas de tension (drains en haute impédance), le couplage capacitif entre grilles et sources des transistors T5 et T6 risque de transmettre vers les drains des transistors à grille flottante des signaux parasites qui peuvent déséquilibrer l'état de la cellule et perturber les sorties OUT, NOUT. Les transistors d'isolation T15, T16 suppriment ce risque.

L'invention est applicable aussi à d'autres types de cellules bistables. Par exemple elle est applicable aux types de cellules décrites dans des demandes de brevet déposées simultanément, dans lesquelles un transistor supplémentaire, commandé par la sortie OUT est intercalé entre le transistor T2 et le transistor T4, ou dans lesquelles la programmation s'effectue non pas par application d'une tension de 5 à 7 volts sur le drain, source à la masse, mais plutôt par application d'une tension de 5 à 7 volts sur la source, le drain étant mis à la masse pour le transistor à programmer et étant laissé en haute impédance pour le transistor à ne pas programmer. Dans ce dernier cas, la tension de programmation VPRG qu'il faut considérer ici est le potentiel de masse.

## Revendications

1. Cellule de mémoire programmable comprenant deux transistors à grille flottante (TGF1, TGF2) et une bascule bistable dont l'état est défini par programmation d'un des deux transisors à grille flottante, de plus comportant deux transistors (T5, T6) pour appliquer sélectivement à l'un seulement des deux transistors à grille flottante une tension (VPRG) permettant sa programmation, l'autre ne recevant pas cette tension, caractérisée en ce qu'un transistor d'isolation (T15, T16) est intercalé entre chaque transistor (T5, T6) d'application de la tension de programmation (VPRG) et le drain du transistor à grille flottante correspondant.

2. Cellule de mémoire selon la revendication 1, caractérisée en ce que la cellule comporte deux branches, chaque branche comportant un transistor à canal P (T1, T2) en série avec le transistor à grille flottante respectif (TGF1, TGF2) de cette branche, le drain du transistor à canal P de l'une des branches étant relié à la grille du transistor à canal P de l'autre branche.

3. Mémoire en circuit intégré comportant une mémoire principale et des circuits de redondance, caractérisée en ce que les circuits de redondance comportent des cellules de mémoire selon l'une des revendications 1 et 2 pour stocker des adresses d'éléments défectueux de la mémoire principale.

4. Mémoire en circuit intégré selon la revendication 3, caractérisée en ce que les transistors d'isolation sont commandés par un signal (CAMSEL), actif pour les rendre conducteurs, le signal actif étant fourni par des circuits de test à un groupe de cellules de mémoire lorsqu'une adresse d'élément défectueux doit être stockée dans ce groupe.

5. Mémoire en circuit intégré selon la revendication 4, caractérisée en ce que le signal (CAMSEL) est rendu inactif en mode d'utilisation normal de la mémoire.

## Patentansprüche

1. Programmierbare Speicherzelle, bestehend aus zwei Transistoren mit Floating Gate (TGF1, TGF2) und einer bistabilen Kippschaltung, deren Zustand durch Programmieren eines der beiden Transistoren mit Floating Gate definiert wird, die zudem zwei Transistoren (T5, T6) aufweist, um wahlweise nur an einen der beiden Transistoren mit Floating Gate eine Spannung (VPRG) anzulegen, die dessen Programmierung ermöglicht, wobei der andere diese Spannung nicht empfängt,
dadurch gekennzeichnet, daß zwischen jeden Transistor (T5, T6) zum Anlegen der Programmierspannung (VPRG) und dem Drain des entsprechenden Transistors mit Floating Gate ein Isoliertransistor (T15, T16) geschaltet wird.

2. Speicherzelle nach Anspruch 1,
dadurch gekennzeichnet, daß die Zelle zwei Zweige aufweist, wobei jeder Zweig einen P-Transistor (T1, T2) in Reihe mit dem jeweiligen Transistor mit Floating Gate (TGF1, TGF2) dieses Zweigs enthält, wobei der Drain des P-Transistors des einen Zweiges mit dem Gate des P-Transistors des anderen Zweiges verbunden ist.

3. Speicher im integrierten Schaltkreis, bestehend aus einem Hauptspeicher und aus Redundanzschaltungen,
dadurch gekennzeichnet, daß die Redundanzschaltungen Speicherzellen gemäß einem der Ansprüche 1 und 2 zur Speicherung der Adressen von defekten Elementen des Hauptspeichers aufweisen.

4. Speicher im integrierten Schaltkreis nach Anspruch 3,
dadurch gekennzeichnet, daß die Isoliertransistoren durch ein Signal (CAMSEL) gesteuert werden, das aktiv ist, um sie leitend zu machen, wobei das aktive Signal von Testschaltungen an eine Speicherzellengruppe abgegeben wird, wenn eine Adresse eines defekten Elements in dieser Gruppe gespeichert werden soll.

5. Speicher im integrierten Schaltkreis nach Anspruch 4,
dadurch gekennzeichnet, daß das Signal (CAMSEL) im normalen Speicher-Verwendungsmodus nichtaktiv geschaltet wird.

## Claims

1. Programmable memory cell comprising two floating gate transistors (TGF1, TFG2) and a bistable flip-flop, the state of which is defined by programming of one of the two floating gate transistors, also including two transistors (T5, T6) for applying selectively to only one of the two floating gate transistors a voltage (VPRG) enabling it to be programmed, the other one not receiving this voltage, characterised in that an isolation transistor (T15, T16) is interposed between each transistor (T5, T6) applying the programming voltage (VPRG) and the drain of the corresponding floating gate transistor.

2. Memory cell according to Claim 1, characterised in that the cell has two arms, each arm including a p-channel transistor (T1, T2) in series with the respective floating gate transistor (TGF1, TFG2) of this arm, the drain of the p-channel transistor of one of the arms being connected to the gate of the p-channel transistor of the other arm.

3. Integrated circuit memory including a main memory and redundancy circuits, characterised in that the redundancy circuits include memory cells according to one of Claims 1 and 2 for storing addresses of defective elements of the main memory.

4. Integrated circuit memory according to Claim 3, characterised in that the isolation transistors are controlled by a signal (CAMSEL), active to make them conductive, the active signal being supplied by test circuits to a group of memory cells when a defective element address is to be stored in this group.

5. Integrated circuit memory according to Claim 4, characterised in that the signal (CAMSEL) is made inactive in the normal utilisation mode of the memory.
